# EUROPEAN PATENT APPLICATION

(11) **EP 4 087 016 A1**
(43) Date of publication of application: **09.11.2022**
(21) Application number: 21171978.6
(22) Date of filing: 04.05.2021
(51) Int. Cl.: H01M 10/613, H01M 10/625, H01M 10/6554, H01M 10/6556, H01M 10/6567, H01M 50/502

(54) **COLD PLATE ASSEMBLY**

(71) Applicant: Rimac Automobiles Ltd., 10431 Sveta Nedelja (HR)
(72) Inventor: Dilberovic, Zlatko, 10410 Velika Gorica (HR)
(74) Representative: Hoffmann Eitle

(57) **Abstract**

A cold plate assembly (10-1) for a battery module comprising a plurality of battery cells, the cold plate assembly comprising: a first cold plate comprising a plurality of openings (111); a second cold plate comprising a plurality of openings (111) and being arranged below the first cold plate such that the openings of the second cold plate are aligned at least in part with the openings of the first cold plate, wherein the second cold plate and the first cold plate are joined together and a plurality of channels for accommodating a cooling fluid are formed between the first cold plate and the second cold plate; and an interconnection layer (14) comprising a plurality of interconnections (141) for electrically connecting the plurality of battery cells and arranged below the second cold plate such that each interconnection is accessible at least in part via an opening of the first cold plate and the corresponding opening of the second cold plate.

## Description

### TECHNICAL FIELD

The present invention relates to the field of battery modules comprising a plurality of battery cells and more particularly to a cold plate assembly for a battery module comprising a plurality of battery cells.

### BACKGROUND

Battery cells and in particular battery modules comprising a plurality of battery cells such as tens, hundreds or even thousands of battery cells densely packed within a limited space of the battery module as well as battery packs comprising one or more such battery modules play an increasing role in renewable energy usage and storage. As an example, in the recent years the popularity and wide use of motor vehicles that entirely or at least in part use electric power stored in one or more such battery packs for propulsion, such as electric vehicles or hybrid vehicles, has increased significantly such that these motor vehicles tend to replace the conventional fuel-based vehicles. Such one or more battery packs in electric vehicles and hybrid vehicles may also be called traction battery packs. On the other hand, also the fuel-based vehicles may use one or more such battery packs as motor vehicle starter battery.

The performance of electric vehicles and hybrid vehicles, such as for example the acceleration process, the maximum achievable speed as well as the electric range i.e. the driving range of the motor vehicle using the electric power stored in the plurality of battery cells of the battery pack is highly dependent on the characteristics of the battery cells and in particular on the storage capacity of the battery cells, the size and weight of the battery cells, but also on the temperature management of the battery cells.

In particular, the temperature of the battery cells is critical for the performance of the battery cells operation, for example for the charge and discharge capacity of the battery cells. The temperature of the battery cells and in particular the temperature management of the battery cells affects also the lifetime of the battery cells and accordingly the lifetime of the battery module and the battery pack. During operation the battery cells produce heat and may also release vent gasses in events such as thermal runaway, overcharge, overheating and similar. Efficient cooling of the battery cells is crucial for the performance of the battery cells. In addition, efficient venting of possible vent gasses adds to safety during operation of the battery pack.

Even further, since the plurality of battery cells are mounted in battery modules, which as elaborated above may house a large number of battery cells for providing the required storage capacity for electric energy, which in turn are mounted in the battery pack comprising normally more than one battery module as elaborated above, it is needed that also such arrangement that enables efficient runaway of the possibly produced vent gases from the battery cells and efficient cooling of the battery cells is provided in the battery pack. Moreover, in the example of electric vehicles and hybrid vehicles, the battery pack is mounted in an available location in the vehicle, such as for example in the floor of the vehicle or in an available space in the luggage compartment of the vehicle and hence has limited dimensions and needs to be compact to fit in the available space. Therefore such arrangement that enables efficient runaway of the possibly produced vent gases from the battery cells and efficient cooling of the battery cells needs to be compatible with the compactness of the battery pack and accordingly needs to fit in the available space in the battery pack.

Therefore, there is a need for providing for an arrangement that enables efficient cooling of the battery cells and efficient runaway of possibly produced vent gases from the battery cells and which in the same time is compatible with the compactness and the limited dimensions of the battery pack.

### SUMMARY

The mentioned problems and objects are met by the subject-matter of the independent claims. Advantageous embodiments are defined in the dependent claims.

According to an aspect of the present invention there is provided a cold plate assembly for a battery module comprising a plurality of battery cells, the cold plate assembly comprising: a first cold plate comprising a plurality of openings; a second cold plate comprising a plurality of openings and being arranged below the first cold plate such that the openings of the second cold plate are aligned at least in part with the openings of the first cold plate, wherein the second cold plate and the first cold plate are joined together and a plurality of channels for accommodating a cooling fluid are formed between the first cold plate and the second cold plate; and an interconnection layer comprising a plurality of interconnections for electrically connecting the plurality of battery cells and arranged below the second cold plate such that each interconnection is accessible at least in part via an opening of the first cold plate and the corresponding opening of the second cold plate.

According to a further aspect of the present invention there is provided a battery module comprising a plurality of battery cells and at least one cold plate assembly according to the previous aspect of the present invention, wherein the plurality of battery cells are electrically connected to each other via the plurality of interconnections of the interconnection layer of said at least one cold plate assembly.

According to a still further aspect of the present invention there is provided a method of assembling the battery module of the previous aspect of the present invention, said method comprising the step of:
electrically connecting, via the openings of the first cold plate and the second cold plate, the plurality of battery cells to the plurality of interconnections of the at least one cold plate assembly.

### BRIEF DESCRIPTION OF THE DRAWINGS

Embodiments of the present invention which are presented for better understanding the inventive concept of the present invention, but which are not to be seen as limiting the present invention, will now be described with reference to the figures in which:
- Figs. 1: shows schematically the battery module according to the embodiment of the present invention;
- Fig. 2: shows schematically the battery module according to the embodiment of the present invention;
- Fig. 3: shows schematically the cold plate assembly according to the embodiment of the present invention;
- Fig. 4A and 4B: show schematically a cross-sectional view of part of the cold plate assembly according to the embodiment of the present invention;
- Fig. 5: shows schematically the cooling fittings of the cold plate assembly according to the embodiment of the present invention;
- Fig. 6: shows schematically a top view of an opening of the cold plate assembly according to the embodiment of the present invention;
- Fig. 7: shows schematically the interconnection layer of two cold plate assemblies according to the embodiment of the present invention;
- Fig. 8: shows schematically the flow of current in the battery module according to the embodiment of the present invention;
- Fig. 9: shows schematically a view from the bottom side of the cold plate assembly according to the embodiment of the present invention;
- Figure 10: shows schematically a view from the top side of the cold plate assembly according to the embodiment of the present invention;

### DETAILED DESCRIPTION

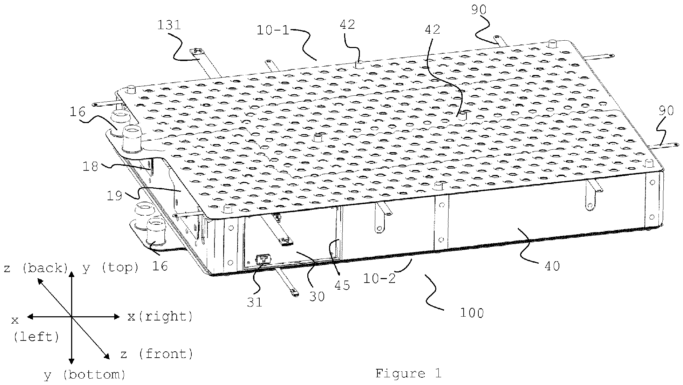

Figure 1 shows schematically a battery module 100 according to the embodiment of the present invention. The battery module 100 comprises a first cold plate assembly 10-1 on the top side and second cold plate assembly 10-2 on the bottom side. The first cold plate assembly 10-1 and the second cold plate assembly 10-2 may also be called a top cold plate assembly 10-1 and a bottom cold plate assembly 10-2, according to the designation "top" and "bottom" in figure 1. However, in other embodiments of the present invention, as will be elaborated further below, the first cold plate assembly 10-1 may be on the bottom side of the battery module 100 while the second cold plate assembly 10-2 may be on the top side of the battery module 100.

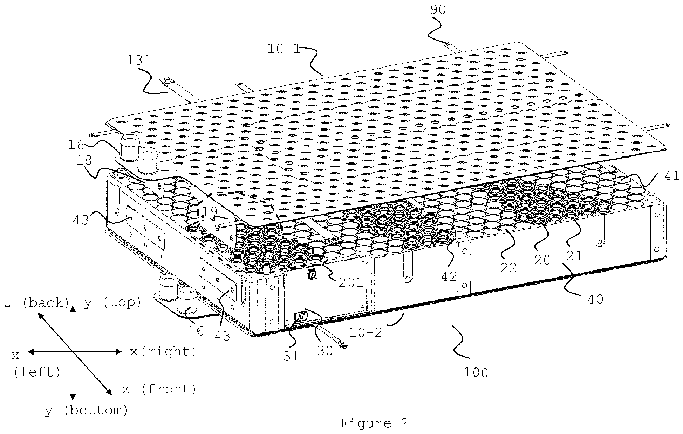

The plurality of battery cells (not visible in figure 1) in the battery module 100 are arranged between the first (top) cold plate assembly 10-1 and second (bottom) cold plate assembly 10-2 (see figure 2) and are electrically connected to each other via the first (top) cold plate assembly 10-1 and second (bottom) cold plate assembly 10-2, details of which are elaborated further below.

Each of the plurality of battery cells 20 is inserted into a through hole of a cell holder 40. Each of the first (top) cold plate assembly 10-1 and second (bottom) cold plate assembly 10-2 is mounted on the cell holder 40. The mounting can be performed by way of using mounting means 42 shown in figure 1, for example nuts and bolts, hinges or similar. The mounting means 42 may be provided (arranged) in mounting points provided at the periphery of the first (top) cold plate assembly 10-1 and second (bottom) cold plate assembly 10-2 and accordingly at the periphery of the cell holder 40. In addition, the mounting means 42 may also be provided (arranged) in mounting points provided on predetermined positions in the central portion of the first (top) cold plate assembly 10-1 and second (bottom) cold plate assembly 10-2 and accordingly in the central portion of the cell holder 40 as shown in figure 1. The number and the position of the provided mounting means 42 and mounting points may depend on the weight of the battery module 100. This may depend on the number of battery cells housed in the battery module 100. Therefore, as the number of battery cells housed in the battery module 100 is increased more mounting means and accordingly more mounting points may be provided.

In other embodiment of the present invention the mounting may be performed by bonding using an adhesive. In still other embodiment of the present invention the mounting may be performed by way of using the described mounting means 42 and by bonding using adhesive.

In addition, the mounting means 42, when provided, may be used for positioning the first (top) cold plate assembly 10-1 and the second (bottom) cold plate assembly 10-2 during the assembly process of the battery module 100.

The cell holder 40 may comprise one or more recesses 45. In each such recess 45 one battery management system (BMS) module 30 may be mounted as elaborated further below. By way of example, in the battery module 100 shown in figure 1 two battery management system modules 30 are provided, one on the front surface of the cell holder 40 and one on the opposite (back) surface of the cell holder 40.

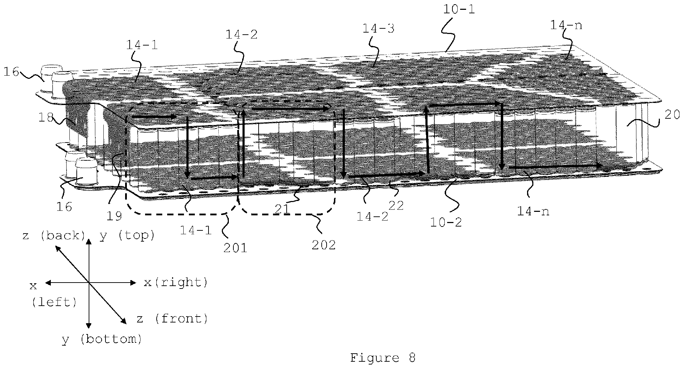

However, the above described cell holder 40 may also be omitted in embodiments of the present invention. In other words, in embodiments of the present invention the battery module 100 may not comprise the mentioned cell holder 40. Put it differently, the plurality of battery cells may be arranged between the first (top) cold plate assembly 10-1 and second (bottom) cold plate assembly 10-2 and electrically connected to each other via the first (top) cold plate assembly 10-1 and second (bottom) cold plate assembly 10-2 without each of the plurality of battery cell being inserted in a through hole of the cell holder 40. For example, the plurality of battery cells may be held in place merely by being electrically connected to each other via the first (top) cold plate assembly 10-1 and second (bottom) cold plate assembly 10-2. Bay way of example, such embodiment of the present invention is shown in figure 8. In a further embodiment of the present invention the plurality of battery cells further to being held in place by being electrically connected to each other via the first (top) cold plate assembly 10-1 and second (bottom) cold plate assembly 10-2 may be additionally supported by other means, for example one or more frames or by using adhesive or potting material.

As shown in figure 1 the shape of the battery module 100 may be that of a rectangular parallelepiped. In other embodiments of the present invention the shape of the battery module 100 may differ from that of a rectangular parallelepiped and may be any kind of other shape depending on the packaging constraints of the battery module 100.

More specifically, according to the embodiment of the present invention, one or more than one battery modules 100 may be packed together, for example in a housing, to form a battery pack (not shown in the figure 1). Accordingly, the battery pack according to the embodiment of the present invention may have a modular arrangement comprising a battery pack housing and one or more battery modules 100. The different battery modules 100 in the battery pack may have different shapes as elaborated above, depending on the packaging constraints of the battery module in the battery pack housing.

As shown in figure 1 each of the first (top) cold plate assembly 10-1 and second (bottom) cold plate assembly 10-2 the battery module 100 comprises features such as cooling connection fittings 16. These cooling connection fittings 16 may comprise at least one inlet member 16 and at least one outlet member 16, details of which are elaborated further below, for distribution of the cooling fluid in each of the first (top) cold plate assembly 10-1 and second (bottom) cold plate assembly 10-2 for cooling the plurality of battery cells.

The first (top) cold plate 10-1 assembly of the battery module 100 may comprise two side connections 18, 19, details of which are elaborated further below, for connecting the main positive and negative terminal of the battery module 100. Even though figure 1 shows the first (top) cold plate 10-1 of the battery module 100 as comprising two side connections 18, 19 (and accordingly, the second (bottom) cold plate assembly 10-2 as not comprising such side connections) in other embodiments of the present invention, as will be elaborated further below, each one of the first cold plate assembly 10-1 and the second cold plate assembly 10-2 may comprise one side connection. In still other embodiments of the present invention the second (bottom) cold plate assembly 10-2 may comprise the two side connections (and accordingly, the first (top) cold plate assembly 10-1 may not comprise such side connections). In these embodiments of the present invention the position of the first (top) cold plate assembly 10-1 and the second (bottom) cold plate assembly 10-2 is reverted.

Each of the first (top) cold plate assembly 10-1 and second (bottom) cold plate assembly 10-2 may further comprise connections 131, details of which are elaborated further below, and/or temperature sensors 90. Specifically, the connections 131 may be used for establishing an electrical connection to the one or more battery management system (BMS) modules 30, via, for example, one or more corresponding connections 31 provided on each battery management system (BMS) module 30.

Figure 2 shows schematically a view of the battery module 100 in which the first (top) clod plate assembly 10-1 is lifted up, provided as an example of the battery module 100 and the construction according to the embodiment of the present invention.

As shown in figure 2, and as elaborated above, the battery module 100 comprises a plurality of battery cells 20 inserted in through holes 41 of the cell holder 40. The battery cells 20 have an elongated form with a positive pole 21 (or terminal) (schematically represented with a plurality of concentric circles) on one axial end and a negative pole 22 (or terminal) (schematically represented as being entirely flat) on the opposite axial end. The plurality of battery cells 20 are arranged parallel to one another along their respective longitudinal axes. The plurality of battery cells 20 are arranged in groups of a predetermined number of battery cells 20. In this embodiment of the present invention, the plurality of battery cells 20 being arranged in groups of a predetermined number of battery cells 20 means that the orientation of the positive pole 21 and negative pole 22 of the battery cells, with respect to the axis denoted as bottom-top in figure 2, alternates between the different groups.

One such group 201 in which the battery cells 20 are arranged such that the positive poles 21 are facing upward (top direction) is shown in figure 2 as being encircled with a dashed line. For the battery cells 20 in the encircled group 201 of battery cells 20 the upper (top) parts of the battery cells 20 are the positive poles 21 of the battery cells 20. Accordingly, in this group of battery cells 20 (the encircled left most group of battery cells 20 in the front part in figure 2) the battery cells 20 are oriented such that the positive pole 21 of each battery cell 20 in this group is facing upward (top side of the battery module 100, top direction on the axis denoted as bottom-top) and the negative pole of each battery cell is facing downward (bottom side of the battery module 100, bottom direction on the axis denoted as bottom-top). In the adjacent group to the first group 201 the battery cells 20 are oriented such that the negative pole 22 of each battery cell 20 in the adjacent group is facing upward (top side of the battery module 100, top direction on axis denoted as bottom-top) and the positive pole 21 of each battery cell 20 in the adjacent group is facing downward (bottom side of the battery module 100, bottom direction of the axis denoted as bottom-top).

In case of different orientation of the battery cells 20 in other embodiment of the present invention in which the positive pole is flipped upside-down, the main positive and negative terminal of the whole battery module 100 are reverted. Accordingly, in this embodiment the present invention the first cold plate assembly 10-1 is on the bottom side of the battery module 100 and the second cold plate assembly 10-2 is on the top side of the battery module 100.

The number of battery cells 20 in each group may vary depending on various design specifications, such as output current and voltage level. The battery cells 20 in each group may be connected in parallel and the different groups may be connected in series as will be elaborated further below. In other embodiments of the present invention other configurations are also possible as will be elaborated further below.

In this embodiment of the present invention shown in figure 2 each of the battery cells 20 is, when the battery module 100 is assembled, inserted in a through hole 41 of the cell holder 40. However, as elaborated above the cell holder 40 may also be omitted as shown in figure 8.

The number of battery cells 20 between all battery modules 100 being arranged in the battery pack may be the same. In a different embodiment of the present invention, the number of battery cells 20 between all battery modules 100 being arranged in the battery pack may be different.

The battery module 100 comprises further at least one battery management system (BMS) module 30 as elaborated above. By way of example, the battery module 100 shown in figure 2 comprises two battery management system (BMS) modules 30, however, in a different embodiment of the present invention the battery module 100 may comprise one battery management system module 30 or more than two battery management system modules 30.

The battery management system module 30 is in general an electronic system comprising one or more electronic circuits for managing the plurality of battery cells 20, for example monitoring the voltage of all or at least part of the battery cells, monitoring the temperature of all or at least part of the battery cells, performing calculations, giving instructions and similar. The BMS 30 may be mounted on the side of the battery module 100, for example may be mounted on the cell holder 40 and more specifically may be mounted in the recess 45 provided in the cell holder 40, as elaborated above.

In this embodiment of the present invention the BMS 30 is the same on all battery modules 100 being arranged in the battery pack. However, in other embodiment of the present invention the BMS 30 on different battery modules 100 arranged in the battery pack may differ from each other, for example due to different number of battery cells 20 arranged in the groups or other reasons. It is also possible that the two BMS provided in the battery module 100 shown in figure 2 differ between each other.

The BMS 30 may comprise at least one connection member 31 for electrically connecting it to the respective connection member 131 of each one of the first (top) cold plate assembly 10-1 and the second (bottom) cold plate assembly 10-2.

Figure 2 shows features of the first (top) cold plate assembly 10-1 and second (bottom) cold plate assembly 10-2 as elaborated with respect to figure 1. More specifically, as elaborated above, each cold plate assembly comprises an inlet member 16 and an outlet member 16 as elaborated above. Further, as elaborated above, the first (top) cold plate assembly 10-1 comprises two side connections 18, 19 arranged to be perpendicular to the plane of the cold plate assembly 10-1 for connecting the main positive and negative terminal of the battery module 100 to respective electrical conductors such as busbars or cables. Such electrical conductors may be mounted on mounting points 43 provided on the corresponding side surfaces of the cell holder 40. Further details of the cold plate assembly 10-1, 10-2 according to the embodiment of the present invention will be elaborated further below.

Each of the plurality of battery cells 20 are electrically connected to each other via the cold plate assemblies 10-1, 10-2 as will be elaborated further below.

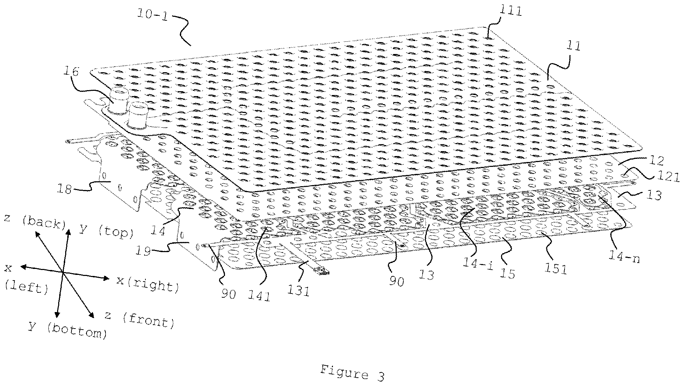

Figure 3 shows further details of the first (top) cold plate assembly 10-1 of the battery module 100 according to the embodiment of the present invention.

The cold plate assembly 10-1 comprises more than one layer that are joined to each other. More specifically, the cold plate assembly 10-1 is a cold plate assembly for the battery cells 20 cooling with interconnections that connect battery cells 20 inside the battery module 100 in series and/or parallel. Insulation layers may also be provided if needed depending on the design specifications.

The cold plate assembly 10-1 comprises a first cold plate comprising a plurality of openings 111 and a second cold plate comprising a plurality of openings 111 and being arranged below the first cold plate such that the openings of the second cold plate are aligned at least in part with the openings of the first cold plate. The first cold plate may also be called here below a top cold plate and the second cold plate may also be called here below a bottom plate. The first cold plate comprising a plurality of openings and the second cold plate comprising a plurality of openings may also be understood as the first and second cold plate being perforated plates. The diameter of the openings 111 of the first cold plate may be the same but may also differ from the diameter of the openings 111 of the second cold plate. The material of the first cold plate and the second cold plate is a heat conductive material. Further, the material of the first cold plate and the second cold plate in some embodiments of the present invention may be electrically conductive material, while in other embodiments of the present invention may be electrically insulating material. By way of specific example, the material of the first cold plate and the second cold plate may be metal such as aluminium, or metal alloy such as steel or may be a polymeric material. The polymeric material may be electrically insulating material. The polymeric material may also be a composite polymeric material. The material of the first cold plate and the second cold plate may be the same. In some embodiments of the present invention the material of the first cold plate may differ from the material of the second cold plate.

The openings 111 of the first cold plate and the second cold plate are used for electrically connecting the battery cells 20, for example using laser welding, as will be elaborated further below. Further, the openings 111 in the first cold plate and the second cold plate enable the venting of the battery cells when exhaust gases are produced. The exhaust gasses of the battery cells, which may be produced in events such as thermal runaway, over-charge, overheating and similar abnormal operation of the battery cells 20 are able to leave the environment of the battery cells 20 via the openings 111 of the first cold plate and the second cold plate. In addition, the openings of the first cold plate and the second cold plate enable end of line testing to be performed on the battery cells 20.

The second cold plate and the first cold plate are joined together and a plurality of channels for accommodating the cooling fluid are formed between the first cold plate and the second cold plate.

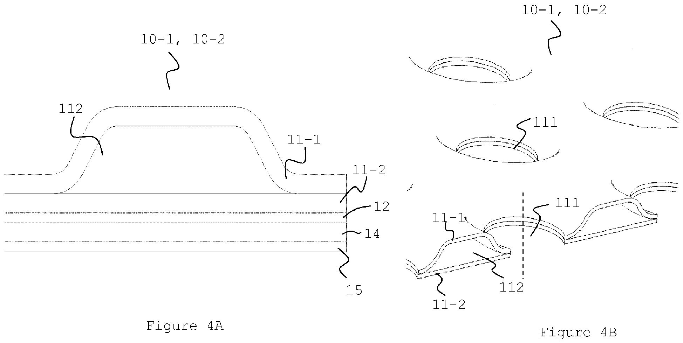

Figures 4A shows schematically a cross-sectional view of a part of the cold plate assembly 10-1, 10-2. Figure 4B shows a cross-sectional view of a part of the cold plate assembly 10-1, 10-2 and more specifically shows schematically a cross-sectional view of the first cold plate 11-1 and the second cold plate 11-2, the openings 111 and a channel 112 formed between the first cold plate 11-1 and the second cold plate 11-2.

The first cold plate 11-1 may have planar shape and/or planar shape with protrusions and/or depressions for forming the plurality of channels 112 for accommodating the cooling fluid. Similarly, the second cold plate 11-2 may have a planar shape and/or planar shape with protrusions and/or depressions for forming the plurality of channels 112 for accommodating the cooling liquid. For example, the second cold plate 10-2 may have planar shape in its entirety while the first cold plate 10-1 may have planar shape with protrusions or projections for forming the plurality of channels for accommodating the cooling fluid. The opposite configuration is also possible.

The first cold plate 11-1 and the second cold plate 11-2 are joined at least in the vicinity of the openings 111 and on the outer periphery. As shown in figures 4A and 4B in this embodiment of the present invention the second cold plate 11-2 is arranged below the first cold plate 11-1 such that the openings 111 of the second cold plate 11-2 are aligned with the openings 111 of the first cold plate 11-1. Here, the openings 111 of the second cold plate 11-2 are aligned with the openings 111 of the first cold plate 11-1 is to be understood such that the axes going through the centre of the openings 111 of the first cold plate 11-1 and the openings 111 of the second cold plate 11-2 (dashed line in figure 4B) are overlapping. In other embodiment of the present invention in which the second cold plate 10-2 is arranged below the first cold plate 10-1 such that the openings 111 of the second cold plate are aligned in part with the openings 111 of the first cold plate these axes may be parallel to each other.

In figures 4A and 4B in the presented part of the cross-section, for example, the second cold plate 11-2 has a planar shape, while the first cold plate 11-1 has planar shape with wave-like protrusions for forming the plurality of channels 112 for accommodating the cooling fluid. The plurality of channels 112 may extend for example in a snake-like manner between the first cold plate 11-1 and the second cold plate 11-2. Figure 4A shows also other features of the cold plate assembly 10-1, 10-2 elaborated in more details with respect to figure 3 below.

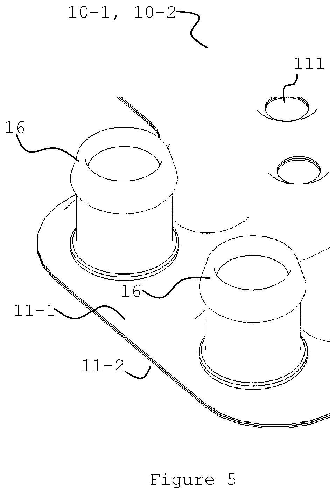

The cold plate assembly 10-1 comprises further cooling connection fittings 16, i.e. at least one inlet member 16 and at least one outlet member 16 for distribution of the cooling fluid in the plurality of channels 112 as elaborated above. Figure 5 shows view of the cooling connection fittings 16. The inlet member 16 and the outlet member 16 have a tubular shape and are arranged on one side of the joined first cold plate 11-1 and second cold plate 11-2 and extend in the direction which is perpendicular to the planar direction of the joined first cold plate 11-1 and second cold plate 11-2. The inlet member 16 and the outlet member 16 are configured to be connected to feedline pipes or tubes for distribution of cooling fluid. The cooling fluid may be stored in a cooling fluid tank. The cooling fluid tank may be arranged in the battery pack or outside of the battery pack. The inlet member 16 and the outlet member 16 may comprise features for connecting them directly or indirectly to pipes or tubes for distribution of the cooling fluid. The cooling fluid is supplied in the plurality of channels 112 through the inlet member 16 and leaves the plurality of channels through the outlet member 16. The cooling fluid that leaves through the outlet member 16 may be stored in a different cooling tank or the same cooling tank. A pump may be used for distributing the cooling fluid. The cooling fluid may be water, oil, a mixture thereof or other suitable cooling fluid.

In a different embodiment of the present invention the inlet member 16 and the outlet member 16 may be arranged on opposite sides of the joined first cold plate 11-1 and second cold plate 11-2 and have a tubular shape that extends along the side of the joined first cold plate 11-1 and second cold plate 11-2 in a direction which is parallel to the plane of the joined first cold plate 11-1 and second cold plate 11-2 instead of extending in the direction which is perpendicular to the planar direction of the joined first cold plate 11-1 and second cold plate 11-2 as shown in figure 5.

The routing of the cooling fluid through the plurality of channels 112 can be designed in a way that gives uniform surface temperature of the first cold plate 11-1 and second cold plate 11-2. For example, the flow of the cooling fluid cab be routed by designing the plurality of channels 112 to represent a through flow, cross flow, return flow or any combination thereof.

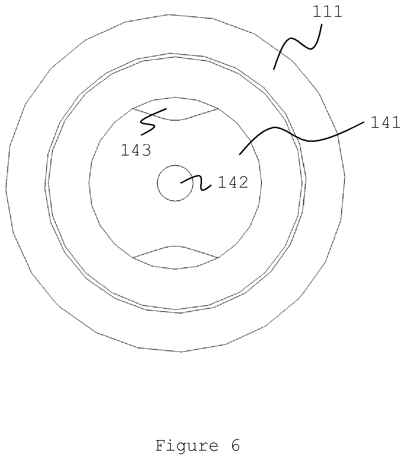

As shown in figure 3 (and figure 4A) the cold plate assembly 10-1 comprises further an interconnection layer 14 comprising a plurality of interconnections 141 (an example of one such interconnections is also shown schematically in figure 6) for electrically connecting the plurality of battery cells 20 (to each other). The interconnection layer 14 is arranged below the second cold plate 11-2 such that each interconnection 141 is accessible (or aligned, or exposed) at least in part via an opening 111 of the first cold plate 11-1 and the corresponding opening 111 of the second cold plate 11-2 as shown in figure 6.

Here, each interconnection 141 being accessible (or aligned or exposed) at least in part via an opening 111 of the first cold plate 11-1 and the corresponding opening 111 of the second cold plate 11-2 indicates that each interconnection 141 is exposed at least in part via the opening 111 of the first cold plate 11-1 and the corresponding opening 111 of the second cold plate 11-2. The number of interconnections 141 can be any needed number from 1 to n. The material of the interconnection layer 14 may be copper or other electrically conducting material.

Figure 6 shows a schematic view of one opening 111 in the first cold plate 11-1 and the second cold plate 11-2 and the corresponding interconnection 141. Each interconnection may comprise a cut-out 143.

Optionally, each interconnection 141 may further comprise an opening 142 as shown in figures 6. The opening 142 is arranged such that it is aligned with the opening 111 of the first cold plate 11-1 and the corresponding opening 111 of the second cold plate 11-2. In this embodiment of the present invention the axes going through the center of the openings 111 of the first cold plate 11-1 and the second cold plate 11-2 as well as the opening 143 of the interconnection 141 overlap. In a different embodiment of the present invention these axes may be parallel to each other.

The cut-out 143 and the opening 142, when provided, enable that each battery cell 20 is vented through the cutout 143 and the opening 142 of the interconnection 141. Even further, by providing the opening 142 and the cutout 143 it is enabled that the weight of the interconnection layer 14, and accordingly the weight of the cold plate assembly 10-1, 10-2 is reduced.

The interconnection layer 14 may have a varying thickness as shown in figure 3. The varying thickness of the interconnection layer 14 may facilitate the joining of the battery cell 20 to the respective interconnection 141. For example, when laser welding is used for joining the battery cell 20 to the respective interconnection 141 the laser welding method requires thinner material to be able to weld to the battery cell 20. This may be achieved with some parts of the interconnection layer 14, for example the each of the plurality of interconnections 141 being thinner than the surrounding parts of the interconnection layer 14. This also enables that that stability of the cold plate assembly 10-1, 10-2 is increased. In a different embodiment of the present invention the interconnection layer 14 may have uniform thickness.

As shown in figure 3 the interconnection layer 14 is divided into a plurality of interconnection members with gaps provided between the interconnection members. Each interconnection member comprises a predetermined number of interconnections 141 from the plurality of interconnections 141 and is being arranged for connecting a group of the plurality of battery cells in parallel and/or series connection.

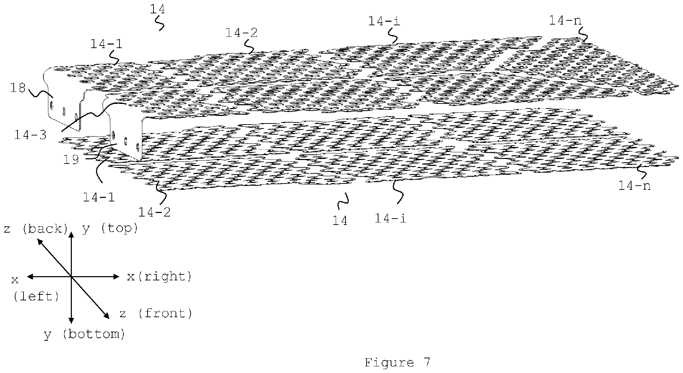

Figure 7 shows schematically the interconnection layer 14 being divided into a plurality of interconnection members 14-1, 14-2, 14-3,...14-n for the battery module 100 respectively for the first (top) cold plate assembly 10-1 (top part in figure 7) and the second (bottom) cold plate assembly 10-2 (bottom part in figure) . As shown in figure 7 the number of interconnection members may differ between the interconnection layer 14 of the first (top) cold plate assembly 10-1 and the second (bottom) cold plate assembly 10-2.

The interconnection layer 14 of the first (top) cold plate assembly 10-1 comprises further the above-elaborated two side connections 18, 19 for connecting the main terminals (the positive terminal and the negative terminal) of the battery module 100 to respective electrical conductors, such as busbars or cables. In this embodiment of the present invention, accordingly the interconnection layer 14 of the bottom cold plate assembly 10-2 does not comprise side connections 18, 19 as also seen in figure 7. In other embodiment of the present invention each of the interconnection layer 14 of the first (top) cold plate assembly 14 and the second (bottom) cold plate assembly 10-2 may comprise one side connection. In still other embodiment of the present invention the position of the interconnection layer 14 of the first (top) cold plate assembly 10-1 and the second (bottom) cold plate assembly 10-2 may be reverted.

Even further, in this embodiment of the present invention the side connections 18, 19 are being shown as being integral with the interconnection layer 14. In other words, in this embodiment of the present invention the side connections 18, 19 are integral parts of the interconnection layer 14 or more specifically are integral parts of a corresponding interconnection member 14-1, 14-3. In a different embodiment of the present invention the side connections 18, 19 may be provided as being detachable from the interconnection layer 14. In other words, according to the present invention, the provision of side members 18, 19 on the first (top) cold plate assembly 10-1 and/or second (bottom) cold plate assembly 10-2 may be carried out depending on the needs in the battery module, for example, depending on the number of battery cells (even or odd number) and/or the orientation of the positive and negative pole of the battery cells in the different groups. The provision of the side connections 18, 19 may be also carried out during the assembly process of the battery module 100. However, this does not affect the basic function of the described cold plate assembly 10-1, 10-2.

An example how each interconnection member 14-1, 14-2,...,14-n is connecting a group of the plurality of battery cells in parallel and/or series is shown in figure 8. Figure 8 shows a plurality of battery cells 20 connected between the first (top) cold plate assembly 10-1 and the second (bottom) cold plate assembly 10-2 in the battery module 100. The arrangement of the plurality of battery cells 20 with respect to their positive terminal 21 and their negative terminal 22 corresponds to the one shown in figure 2. As shown in figures 2 and 8 the plurality of battery cells 20 are arranged in groups having alternating polarity. For example, in figure 8 in the group 201 at the left most front side of the battery module 100 the battery cells are arranged such that the positive pole 21 of each battery cell 20 is facing the top side of the battery module 100 and the negative pole 22 of each battery cell 20 is facing the bottom side of the battery module. In the adjacent group 202 the battery cells 20 are oriented in the opposite manner i.e. the negative pole 22 of each battery cell 20 is facing the top side of the battery module 100 and the positive pole 21 of each battery cell 20 is facing the bottom side of the battery module.

The current flows from the first main terminal of the battery module on the left (front or back) side (side connection 18 or side connection 19 in figure 8) in an alternate manner between an interconnection member of the first (top) cold plate assembly 10-1 and an interconnection member at the second (bottom) cold plate assembly 10-2 towards the second main terminal of the battery module on the left (back or front) side (side connection 19 or side connection 18 respectively) . In this embodiment of the present invention, the interconnection members 14-1, 14-2,...,14-n connects the plurality of battery cells 20 in the respective group in parallel, while the different groups are connected in series. Other configurations are also possible as will be elaborated further below. The number of interconnection members 14-1, 14-2,...,14-n is equal to the number of groups of battery cells plus 1.

Accordingly, the plurality of interconnection members 14-1, 14-2,...14-n increases the flexibility in providing parallel and/or series connection between the plurality of battery cells 20 which in turn increases the flexibility in providing battery module with desired values for the output current and voltage level.

The cold plate assembly 10-1 comprises further a flexible printed circuit board 13. The flexible printed circuit board 13 may be arranged at least in part in one or more of the gaps provided between the interconnections members 14-1, 14-2,...,14-n. As shown in figure 3 the flexible printed circuit board 13 is arranged in the plane of the interconnection layer 14. The flexible printed circuit board 13 may consist of a thin polymer film having conductive circuit patterns affixed thereto.

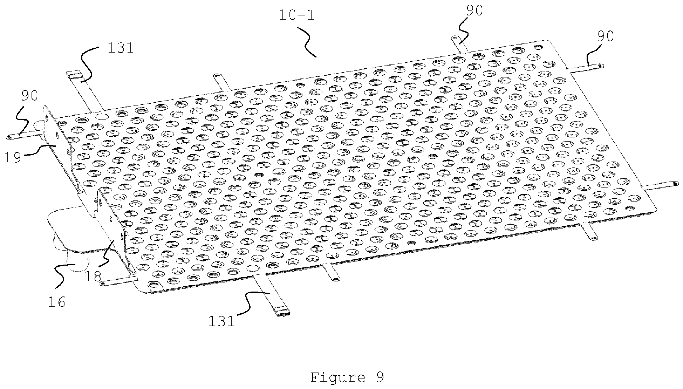

The flexible printed circuit board 13 comprises at least one connection 131 for connecting the flexible printed circuit board 13 to the at least one BMS 30. Detailed view of this connection 131 is shown in figure 9. Through this connection it is enabled that different measurement values and/or signals from the cold plate assembly 10-1, 10-2, examples of which are elaborated here below, are send to (or reach) the BMS 30 that further processes the obtained values.

By way of example, the flexible printed circuit board 13 may comprise connection points for temperature sensors 90, arranged on a frame around the periphery of the cold plate assembly 10-1 as shown in figure 3 or may comprise integrated temperature sensors (not shown in the figures).

Even further, in embodiments of the present invention in which the material of the first cold plate 11-1 and/or the second cold plate 11-2 is electrically conducting material such as metal or electrically conducting metal alloy as elaborated above, the flexible printed circuit board 13 may be provided with, or comprise, at least one connection point or connection member (not shown in the figures) arranged to be electrically connected to a corresponding at least one connection point or connection member provided in the first cold plate 11-1 and/or second cold plate 11-2 for electrically connecting the flexible printed circuit board 13 with the first cold plate 11-1 and/or second cold plate 11-2. By connecting the corresponding connection points or connection members a (direct) electrical connection may be established between the flexible printed circuit board 13 and the first cold plate 11-1 and/or second cold plate 11-2. This enables the battery management system module 30 to monitor (via the flexible printed circuit board 13) if there is an insulation breach between any of the battery cell groups and the first cold plate 11-1 and/or second cold plate 11-2 which is made of material that is electrically conducting material such as metal or metal alloy. This enhances the safety of the battery module 100.

In addition, or alternatively, in the embodiments of the present invention in which the material of the first cold plate 11-1 and/or the second cold plate 11-2 is electrically conducting material such as metal or electrically conducting metal alloy as elaborated above, the first cold plate 11-1 and/or the second cold plate 11-2 may be provided with, or comprise, at least one connection point or connection member arranged to be electrically connected to a corresponding connection point or connection member of the at least one battery management system (BMS) module 30 for electrically connecting the first cold plate 11-1 and/or the second cold plate 11-2 with the at least one BMS 30. In the battery management system (BMS) module 30 the corresponding connection or connection point may be the above-elaborated connection 31 or a similar connection. In this way, the battery management system module 30 may also be directly connected to the first cold plate 11-1 and/or the second cold plate 11-2 to monitor if there is an insulation breach between any of the battery cell groups and the first cold plate 11-1 and/or second cold plate 11-2 which is made of material that is electrically conducting material such as metal or metal alloy.

The (direct) electrical connection between the at least one connection point that may be provided on the flexible circuit board 13 and the corresponding connection point on the first cold plate 11-1 and/or second cold plate 11-2 may be established in different ways. By way of example, the electrical connection may be established by bonding, welding or soldering. In this way an electrical connection between the first cold plate 11-1 and/or the second cold plate 11-2 and the BMS 30 is established via the flexible printed circuit board 13.

In addition, the flexible printed circuit board 13 may comprise a plurality of conductive links (not shown in the figure) each link extending to an interconnection 141 and being arranged for measuring a voltage of the corresponding battery cell 20 when connected to the interconnection 141. With these conductive links the voltage of each cell may be monitored by the BMS 30. These conductive links may be designed in a way to form fusible links or to have fuses or other electrical components, for examples resistors, current sensors and similar, embedded in.

Hence, the flexible printed circuit board 13 serves as an electrical connection between the different elements, such as temperature sensors 90 or conductive links or first cold plate 11-1 and second cold plate 11-2 and the BMS 30, enabling that the corresponding measurement values, for example by the temperature sensors 90 or the voltage values measured using the conductive links or the voltage values indicating whether an isolation breach between any of the battery cells groups and the first cold plate 11-1 and/or the second cold plate 11-2 has occurred as elaborated above are send to (or reach) the BMS 30 that receives this values and further processes the received values, for example monitors the temperature of the battery module, monitors the voltage of each battery cells 20, monitors if there is an insulation breach between any of the battery cell groups and the first cold plate 11-1 and/or second cold plate 11-2 and similar. Therefore, the provision of the flexible printed circuit board 13 is useful for enhancing for example the safety of the battery module but it is not to be seen as limiting to the present invention.

The cold plate assembly 10-1 comprises further a first electrically insulating layer 12 arranged between the second cold plate 11-2 and the interconnection layer 14 (shown in figure 3 and figure 4a). The first insulating layer 12 comprises openings 121. The openings 121 are aligned at least in part with the openings 111 of the first cold plate 11-1 and the second cold plate 11-2. The first electrically insulating layer 12 may in addition be thermally conductive for aided cooling performance. The material of the first electrically insulating material 12 may be a polymer, ceramic or mineral based material or any combination of the above-mentioned types. In embodiments of the present invention in which the second cold plate 11-2 is made of electrically insulating material the first electrically insulating layer 12 may be omitted.

The cold plate 10-1 assembly may comprise further a second electrically insulating layer 15 arranged below the interconnection layer 14. The second insulating layer 15 comprises openings 151. The openings 151 are aligned at least in part with the plurality of interconnections 141. The material of the second electrically insulating layer 15 may be a polymer, ceramic or mineral based material or any combination of the above-mentioned types. In addition, the material of the first insulating layer 12 and the second insulating layer 15 may be the same material but may also be different material.

In embodiments of the present invention any of the above-mentioned layers may have integrated electrical conduits to form a flexible printed circuit board. In this way, in embodiments of the present invention the flexible printed circuit board 13 may be replaced by providing in any of the above-mentioned layers integrated electrical conduits. In other words, in embodiments of the present invention a large flexible printed circuit board may be provided to replace any of the layers and still maintain the functionality of the described flexible printed circuit board 13. In embodiments of the present invention the second insulating layer 15 may be omitted if the design of the battery module 100 permits it.

As further shown in figure 3 the cold plate assembly 10-1 may comprise a plurality of temperature sensors 90. The plurality of temperature sensors 90 may be arranged in a frame surrounding the interconnection layer 14. In a different embodiment of the present invention the flexible printed circuit board 13 may comprise one or more temperature sensors as elaborated above. The temperature sensors 90 may have elongated form and may extend in a direction which is perpendicular to the plane of the cold plate assembly 10-1 and are arranged to be fixed on at least one battery cell.

Figure 9 shows a view of the first cold plate assembly 10-1 (top cold plate assembly 10-1) from the lower side (the side of the second electrically insulating layer 15). The connection 131 of the flexible printed circuit board 13 for connecting it to the BMS 30 is also shown.

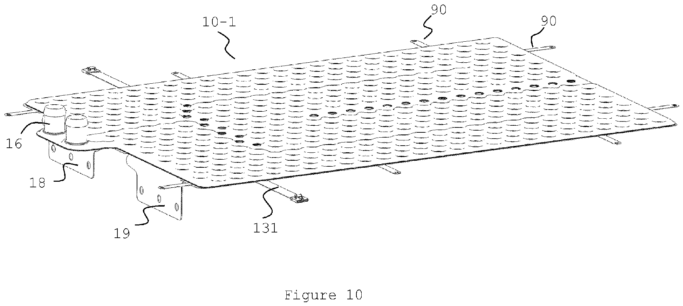

Figure 10 shows a view the first cold plate assembly 10-1 (top cold plate assembly 10-1) from the top side.

As shown in figures 9 and 10 the temperature sensors 90 and the at least one connection 131 of the flexible printed circuit board 13 for connecting it to the BMSs 30 may also extend in the plane of the cold plate assembly 10-1 and may be bent such that they extend in the direction perpendicular to the plane of the cold plate assembly 10-1 as elaborated above during the assembling of the battery module 100.

Cooling of the plurality of battery cells 200 is achieved via the first cold plate assembly 10-1 and the second cold plate assembly 10-2 and more particularly, via the first cold plate 11-1 and the second cold plate 11-2 arranged such as to be joined together and plurality of channels for accommodating the cooling fluid being formed between them. Venting of the plurality of battery cells 20 by enabling the possibly produced exhaust gases to escape the environment of the plurality of battery cells 20 is achieved via the plurality of openings 111 in the first cold plate 11-1 and second cold plate 11-2 which are arranged directly above each battery cell 20. In addition, the same openings 111 are used for electrically connecting, for example via laser welding, the interconnections 141 to the respective battery cells 20. These openings 111 also enable performing end of line testing on the plurality of battery cells 20. The interconnection layer, comprising the plurality of interconnections enables that the plurality of battery cells are electrically connected to each other.

In the following the steps of the assembling of the battery module 100 according to the embodiment of the present invention will be elaborated with reference to figure 1 and figure 2.

In a first step the plurality of battery cells 20 are inserted in the through holes 41 of the cell holder 40 and are fixed therein. The plurality of battery cells 20 may be fixed in the respective through holes 41, for example, by gluing. In a different embodiment of the present invention, in which the cell holder 40 is not provided in the battery module 100 in a preceding step the plurality of battery cells 20 may, for example, be aligned so that they can be electrically connected to the respective interconnections 141 of the cold plate assembly 10-1, 10-2.

In a second step the plurality of battery cells 20 are electrically connected, via the openings 111 of the first cold plate 10-1 and the second cold plate 10-2, to the plurality of interconnections 141 of at least one cold plate assembly 10-1. Accordingly, the cold plate assembly 10-1 comes as a single part in the assembly process. The different layers on the cold plate assembly are joined together. In this embodiment of the present invention, as shown in figure 1 and figure 2, the battery module 100 comprises two cold plate assemblies 10-1, 10-2 so that the plurality of battery cells 20 are electrically connected to the interconnections 141 of the interconnection layers 14 of the first cold plate assembly 10-1 and second cold plate assembly 10-2 respectively. The steps of electrically connecting may be performed simultaneously for the first cold plate assembly 10-1 and the second cold plate assembly 10-2 or may be performed one after the other. The step of electrically connecting may involve, for example, any one of laser welding, ribbon welding, ultrasonic welding, wire bonding, ribbon bonding, tungsten inert gas (TIG) welding, resistance welding and soldering.

In a third step the plurality of temperature sensors 90, when provided, are fixed to the respective battery cells 20. The fixing may involve fixing by gluing, potting or applying mechanical pressure. In the embodiment of the present invention in which the temperature sensors 90 are not integrated in the flexible printed circuit board 13, the plurality of temperature sensors 90 are electrically connected to the corresponding connection points on the flexible printed circuit board 13 in a further step.

In a fourth step the at least one BMS 30 is installed and is electrically connected to the flexible printed circuit board 13. If applicable, the at least one BMS is electrically connected to the first cold plate 10-1 and/or second cold plate 10-2. For example, in this embodiment of the present invention, the at least one BMS is installed in the corresponding recess provided in the cell holder 40 and fixed by gluing or using mechanical means, for example nuts and bolts.

As elaborated above, in the present invention the battery module 100 comprises a first (top) cold plate assembly 10-1 and a second (bottom) cold plate assembly 10-2. As further elaborated above in this embodiment of the present invention the first (top) cold plate assembly 10-1 comprises side connections 18, 19 for connecting the main positive and main negative terminal of the battery module to electrical connectors such as busbars and cables. As elaborated above, in this embodiment of the present invention one pole of each of the plurality of battery cells 20 is connected to an interconnection 141 of the interconnection layer 14 of the first cold plate assembly 10-1 and the other pole of each of the plurality of battery cells 20 is connected to an interconnection 141 of the interconnection layer 14 of the second (bottom) cold plate assembly 10-2. This is also shown in figure 8.

As further elaborated above, in a different embodiment of the present invention, for example in specific variation of the above-described embodiment, in which different battery cell 20 orientation is applied such that the battery cells 20 are flipped upside-down with respect to the orientation shown in figures 1, 2 and 8 the main terminals of the whole battery module revert and accordingly the position of the first (top) cold plate assembly 10-1 and the second (bottom) cold plate assembly 10-2 is reverted. In other words, in such battery module 100 the first cold plate assembly 10-1 is mounted at the bottom and the second cold plate assembly 10-2 is mounted at the top of the battery module 100.

Other configurations according to other embodiments of the present invention, for example one or more specific variations of the above-described embodiment of the present invention are also possible.

For example, in a further embodiment of the present invention, the plurality of battery cells 20 are all oriented in the same way inside the battery module, for example the positive pole of all battery cells 20 is facing the top side and the negative pole of all battery cells 20 is facing the bottom side of the battery module 100. In this embodiment of the present invention the battery module comprises at least one cold plate assembly provided on one side, for example on the top side when the positive poles are facing the top side. In this embodiment of the present invention series and parallel connections are achieved with one cold plate assembly only. In the battery module in this embodiment a simple support may be mounted on the bottom side, or if the battery cells are inserted in the described cell holder 40 the support may even be omitted. Even further a bare cold plate that has merely a function of cooling the negative poles of the battery cells 20 may be arranged on the bottom side. For example, such bare cold plate may comprise the first cold plate 10-1 and the second cold plate 10-2 elaborated above.

In still other embodiment of the present invention the battery module may be provided with one cold plate assembly on one side with both poles of each battery cell connected to the interconnections 141 of the interconnection layer 14 of the cold plate assembly.

In even further embodiment of the present invention the battery module may comprise two cold plate assemblies, one provided on the top and one on the bottom, wherein each of the cold plate assemblies comprises one side connection for the main positive and main negative terminal of the battery module. In this embodiment the battery module may comprise odd number of battery cells connected in series and hence one main terminal of the battery module is connected to each one of the cold plate assemblies.

In summary, as elaborated above cooling of the plurality of battery cells 20 is achieved via the first cold plate assembly 10-1 and the second cold plate assembly 10-2 and more particularly, via the first cold plate 11-1 and the second cold plate 11-2 arranged such as to be joined together and plurality of channels for accommodating the cooling fluid being formed between them. Venting of the plurality of battery cells 20 by enabling the possibly produced exhaust gases to escape the environment of the plurality of battery cells 20 is achieved via the plurality of openings 111 on the first cold plate 11-1 and second cold plate 11-2 which are arranged directly above each battery cell 20. In addition, the same openings 111 are used for electrically connecting, for example via laser welding, the interconnections 141 to the respective battery cells 20. These openings 111 also performing end of line testing on the plurality of battery cells 20. The interconnection layer, comprising the plurality of interconnections enables that the plurality of battery cells are electrically connected to each other. In addition, since the interconnection layer is divided into plurality of interconnection members as elaborated above the flexibility in providing parallel and/or series connection between the plurality of battery cells is increased.

Although detailed embodiments have been described, these only serve to provide a better understanding of the invention defined by the appended claims and are not be seen as limiting.

## Claims

1. A cold plate assembly for a battery module comprising a plurality of battery cells, the cold plate assembly comprising:
a first cold plate comprising a plurality of openings;
a second cold plate comprising a plurality of openings and being arranged below the first cold plate such that the openings of the second cold plate are aligned at least in part with the openings of the first cold plate,
wherein the second cold plate and the first cold plate are joined together and a plurality of channels for accommodating a cooling fluid are formed between the first cold plate and the second cold plate; and
an interconnection layer comprising a plurality of interconnections for electrically connecting the plurality of battery cells and arranged below the second cold plate such that each interconnection is accessible at least in part via an opening of the first cold plate and the corresponding opening of the second cold plate.

2. The cold plate assembly of claim 1, wherein
each interconnection comprises a cutout, said cutout being aligned at least in part with the opening of the first cold plate and the corresponding opening of the second cold plate.

3. The cold plate assembly of claim 1 or claim 2, wherein
each interconnection further comprises an opening, said opening being arranged such that it is aligned with the opening of the first cold plate and the corresponding opening of the second cold plate.

4. The cold plate assembly of any one of claims 1 to 3, wherein the interconnection layer is divided into a plurality of interconnection members with gaps provided between the interconnection members, wherein each interconnection member comprises a predetermined number of interconnections from the plurality of interconnections and is being arranged for connecting a group of the plurality of battery cells in parallel and/or series connection.

5. The cold plate assembly according to any one of claims 1 to 4, further comprising a first electrically insulating layer arranged between the second cold plate and the interconnection layer,
wherein the first insulating layer comprises openings, said openings being aligned at least in part with the openings of the first cold plate and the second cold plate.

6. The cold plate assembly according to any one of claims 1 to 5, further comprising a second electrically insulating layer arranged below the interconnection layer, said second insulating layer comprising openings, said openings being aligned at least in part with the plurality of interconnections.

7. The cold plate assembly according to any one of claims 1 to 6, wherein the first cold plate and the second cold plate have planar shape with protrusions and/or depressions for forming the plurality of channels for accommodating the cooling fluid.

8. The cold plate assembly according to any one of claims 1 to 7, further comprising a plurality of temperature sensors, each temperature sensor being arranged for measuring the temperature of at least one battery cell.

9. The cold plate assembly of any one of claims 1 to 8, further comprising a flexible printed circuit board, said flexible printed circuit board being arranged at least in part in one or more of the gaps provided between the interconnection members.

10. The cold plate assembly according to claim 9, wherein the flexible printed circuit board comprises a plurality of conductive links, each link extending to an interconnection and being arranged for measuring a voltage of the corresponding battery cell when connected to the interconnection.

11. The cold plate assembly according to any one of claims 9 and 10, wherein the flexible printed circuit board is provided with at least one connection point arranged to be electrically connected to a corresponding at least one connection point provided on the first cold plate and/or the second cold plate, wherein the material of the first cold plate and/or second cold plate is electrically conducting material.

12. The cold plate assembly according to any one of claims 1 to 11, further comprising at least one inlet member and one outlet member for distribution of the cooling fluid in the plurality of channels.

13. The cold plate assembly according to any one of claims 1 to 12, wherein the material of the first cold plate and the second cold plate is a heat conductive material.

14. A battery module comprising a plurality of battery cells and at least one cold plate assembly according to any one of claims 1 to 13, wherein the plurality of battery cells are electrically connected to each other via the plurality of interconnections of the interconnection layer of said at least one cold plate assembly.

15. A method of assembling the battery module of claim 14, said method comprising the step of:
electrically connecting, via the openings of the first cold plate and the second cold plate, the plurality of battery cells to the plurality of interconnections of the at least one cold plate assembly.
